(19) **Europäisches Patentamt / European Patent Office / Office européen des brevets**

(11) **EP 1 775 647 A1**

(12) **EUROPEAN PATENT APPLICATION**
published in accordance with Art. 158(3) EPC

(43) Date of publication:
**18.04.2007 Bulletin 2007/16**

(51) Int Cl.:
*G04B 19/06* [(2006.01)]  *G02B 5/30* [(2006.01)]
*H01L 31/04* [(2006.01)]

(21) Application number: **05765391.7**

(22) Date of filing: **28.06.2005**

(86) International application number:
**PCT/JP2005/011811**

(87) International publication number:
**WO 2006/006390 (19.01.2006 Gazette 2006/03)**

(84) Designated Contracting States:
**DE GB IT**

(30) Priority: **07.07.2004 JP 2004200398**

(71) Applicant: **SEIKO EPSON CORPORATION**
**Shinjuku-ku**
**Tokyo 163-0811 (JP)**

(72) Inventors:
• **Kojima, Kazuyuki;**
**c/o Seiko Epson Corporation**
**Suwa-shi, Nagano;3928502 (JP)**

• **Nakanishi, Nobuhiko;**
**c/o Seiko Epson Corporation**
**Suwa-shi, Nagano;3928502 (JP)**

(74) Representative: **Wiedemann, Peter**
**Hoffmann - Eitle**
**Patent- und Rechtsanwälte**
**Arabellastrasse 4**
**81925 München (DE)**

(54) **DIAL OF SOLAR CLOCK AND CLOCK**

(57) The object of the invention is to provide a solar timepiece dial having excellent optical transparency and decorativeness (aesthetic appearance) and to provide a timepiece that can supply a sufficient amount of external light to a solar battery and has excellent decorativeness. The solar timepiece dial 1 is configured to be used in a solar timepiece equipped with a solar battery 9 and includes a substrate 11 made of a material having optical transparency, a polarizer 13 provided on the surface of the substrate 11 that faces the solar battery 9 and functioning to polarize incident light, and a diffusion layer 12 that is made of a material containing a diffusing agent functioning to diffuse incident light and arranged between the substrate 11 and the polarizer 13. The polarizer 13 is configured to transmit a first light that vibrates in a prescribed direction and reflect a second light having a vibrational direction that is perpendicular to the vibrational direction of the first light.

Fig. 1

**Description**

Technical Field

The present invention relates to a solar timepiece dial and a timepiece.

Background Art

Timepiece (watch) dials are required both to function as practical components and to possess the decorativeness (aesthetic appearance) of decorative components. Particularly, in solar timepieces equipped with a solar battery in which the solar battery (solar cell) is arranged under the dial (solar timepiece dial), the dial needs to have excellent optical transparency and also possess the decorativeness (aesthetic appearance) of a decorative component.

More specifically, as for the optical transparency, a solar timepiece dial must allow an amount of light sufficient to drive the timepiece to pass through the solar battery arranged therebelow while, simultaneously, possessing the decorativeness of a decorative component.

In order to ensure that a sufficient amount of light is caused to be incident to the solar battery, some conventional solar timepieces use the solar battery itself as the dial and other conventional timepieces use a dial that is designed such that no colored parts (particularly darkly colored members) are arranged over the solar battery and has a color similar to that of the solar battery (normally black or purple).

However, in recent years, there is a strong demand for dials of various colors to be used in solar timepieces depending on the specifications of the timepiece. More particularly, there is a strong demand for bright colored and light colored (e.g., white) solar timepiece dials that also possess an excellent aesthetic appearance (high-quality appearance).

Solar timepiece dials employing ceramic as their main constituent material have been used in an attempt to prevent the solar battery from being visible through the dial (e.g., Patent Document 1), but such dials are expensive and are problematic in terms of strength because they break easily when dropped or otherwise subjected to physical shock.

[Patent Document 1] JP-A-10-39048 (claims and Paragraph 0060)

Disclosure of the Invention

The object of the invention is to provide a solar timepiece dial having excellent optical transparency and decorativeness (aesthetic appearance) and to provide a timepiece that can supply a sufficient amount of external light to a solar battery and has excellent decorativeness.

In order to achieve the above object, the invention provides a solar timepiece dial used in a solar timepiece equipped with a solar battery. The solar timepiece dial includes: a substrate made of a material having optical transparency; a polarizer provided on the surface of the substrate that faces the solar battery and functioning to polarize incident light; and a diffusion layer made of a material containing a diffusing agent functioning to diffuse incident light and arranged between the substrate and the polarizer.

As a result, a solar timepiece dial having excellent optical transparency and excellent decorativeness (aesthetic appearance) can be provided.

In the solar timepiece dial according to the invention, it is preferable that the polarizer be a reflective polarizer configured to transmit a first light that vibrates in a prescribed direction and reflect a second light having a vibrational direction that is perpendicular to the vibrational direction of the first light.

By employing such a polarizer, the solar timepiece dial can effectively prevent the base color of the solar battery from being visible therethrough while also possessing sufficiently high optical transparency and can be imparted with particularly excellent decorativeness (aesthetic appearance).

In the solar timepiece dial according to the invention, the polarizer is preferably a film formed by laminating a plurality of layers.

By employing such a polarizer, the solar timepiece dial can more effectively prevent the base color of the solar battery from being visible therethrough while also possessing sufficiently high optical transparency and can be imparted with particularly excellent decorativeness (aesthetic appearance).

In the solar timepiece dial according to the invention, the polarizer is preferably a film formed by alternately laminating a layer made mainly of polyethylene naphthalate and a layer made mainly of co-polyester of naphthalene dicarbonate and terephthalate.

By employing such a polarizer, the solar timepiece dial can more effectively prevent the base color of the solar battery from being visible therethrough while also possessing sufficiently high optical transparency and can be imparted with particularly excellent decorativeness (aesthetic appearance).

In the solar timepiece dial according to the invention, the polarizer is preferably made mainly of a polyester resin.

By making the polarizer out of a polyester resin, the overall optical transmittance of the solar timepiece dial decreases and the base color of the solar battery can be prevented even more effectively from being visible through the dial. Also, when a white substrate is used, the whiteness of the solar timepiece dial as a whole can be improved.

In the solar timepiece dial according to the invention, the diffusion layer is preferably made of a material having an adhesive or bonding property.

By making the diffusion layer out of such a material, the adhesiveness between the substrate and the polarizer can be improved, and consequently the shock resistance of the solar timepiece dial can be improved, enabling the solar timepiece dial to function exceptionally reliably as both a practical component and a decorative component.

In the solar timepiece dial according to the invention, the diffusion layer is preferably made mainly of an acrylic adhesive.

By making the diffusion layer mainly out of an acrylic adhesive, particularly excellent adhesiveness can be achieved between the substrate and the polarizer while sufficiently maintaining the optical transparency and aesthetic appearance of the overall solar timepiece dial.

In the solar timepiece dial according to the invention, the substrate is preferably made mainly of polycarbonate and/or an acrylonitrile-butadiene-styrene copolymer.

By making the substrate out of such a material, for example, particularly excellent adhesiveness can be obtained between the substrate and the diffusion layer. Additionally, a solar timepiece dial having particularly excellent strength can be obtained as a whole, and the degree of freedom with respect to molding the solar timepiece dial (substrate) during manufacturing thereof can be increased (i.e., the dial is easier to form). Furthermore, a printed layer can be appropriately formed on the surface of the substrate.

In the solar timepiece dial according to the invention, it is preferable that the optical transmittance of visible light traveling from the side where the substrate is provided to the side where the polarizer is provided be 20% or higher.

When the optical transmittance is 20% or higher, the light incident on the solar timepiece dial can be caused to be more efficiently incident on the solar battery while sufficiently maintaining the excellent decorativeness (aesthetic appearance) of the solar timepiece dial (and of the entire timepiece in which the solar timepiece dial is provided).

The solar timepiece dial according to the invention preferably possesses a white external appearance.

When the external appearance is white, a solar timepiece dial that exudes particularly excellent decorativeness (especially a feeling of high quality) can be obtained.

The solar timepiece dial according to the invention is preferably a dial for a wristwatch.

Wristwatches are typically not used under fixed environmental circumstances and thus wristwatches need to possess excellent decorative and practical properties suitable for a variety of environments. Furthermore, the wristwatch dial used in a solar wristwatch (solar wristwatch dial) needs to have particularly excellent decorativeness and optical transparency as compared with other solar timepiece dials. Therefore, although the invention is applicable to various timepiece dials (solar timepiece dials), it is particularly well suited for wristwatch dials.

The invention also provides a timepiece including: a solar battery; a substrate made of a material having optical transparency; a polarizer provided on the surface of the substrate that faces the solar battery and functioning to polarize incident light; a diffusion layer made of a material containing a diffusing agent functioning to diffuse incident light and arranged between the substrate and the polarizer.

As a result, a sufficient amount of external light can be supplied to the solar battery, and a timepiece (solar timepiece) having excellent decorativeness can be provided.

The timepiece according to the invention is also provided with a solar timepiece dial according to the invention.

As a result, a sufficient amount of external light can be supplied to the solar battery, and a timepiece (solar timepiece) having excellent decorativeness can be provided.


Brief Description of the Drawings

Fig. 1 is a sectional view showing a preferred embodiment of a solar timepiece dial according to the invention.

Fig. 2 is a schematic view showing a preferred embodiment of a polarizer which can be used in the invention and which is formed by laminating a plurality of layers.

Fig. 3 is a partially sectional view showing a preferred embodiment of a wristwatch (portable timepiece) according to the invention.


Best Mode for Carrying Out the Invention

Preferred embodiments of the invention will now be described with reference to the accompanying drawings.

First, a preferred embodiment of a solar timepiece dial according to the invention will be described.

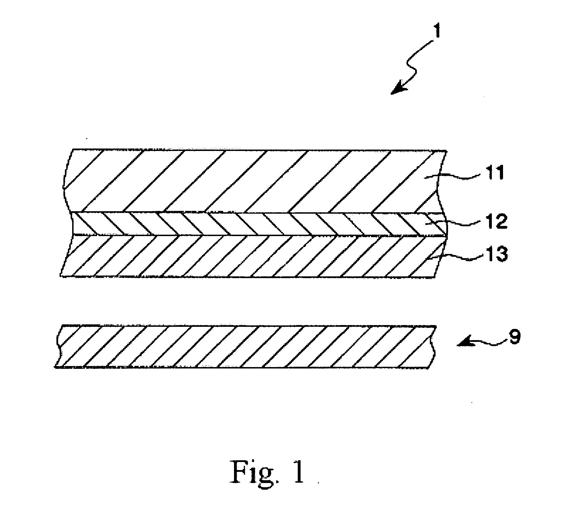

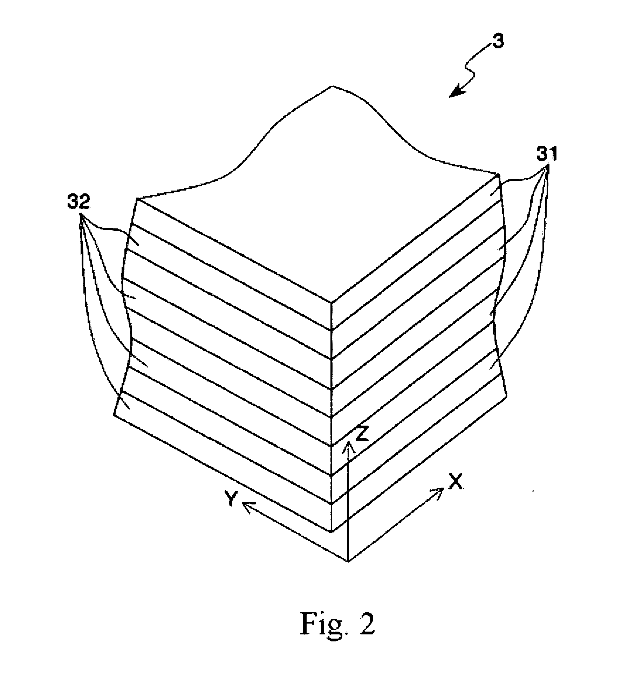

Fig. 1 is a sectional view of a preferred embodiment of a solar timepiece dial according to the invention, and Fig. 2 is a schematic view of a preferred embodiment of a polarizer which is formed by laminating a plurality of layers.

The solar timepiece dial 1 is configured to be used in a solar timepiece equipped with a solar battery 9.

As shown in Fig. 1, the solar timepiece dial 1 of this embodiment has a substrate 11, a polarizer 13 provided on the side of the substrate 11 that faces the solar battery 9, and a diffusion layer (diffuser) 12 arranged between the substrate 11 and the polarizer 13.

Thus, since it has a diffusion layer and a polarizer, a solar timepiece dial according to the invention can effectively prevent the base color of the solar battery from being visible therethrough while also possessing sufficiently high optical transparency. The solar timepiece dial also has particularly excellent decorativeness (aesthetic appearance).

The substrate 11, the diffusion layer 12, and the polarizer 13 will now be described in detail.

[Substrate]

The substrate 11 is made of a material having optical transparency.

The substrate 11 can be made of, for example, any of various plastic, glass, and ceramic materials, but it is preferred that the substrate 11 be made of plastic (particularly heat-resistant plastic). By using plastic, a solar timepiece dial 1 that is, for example, comparatively lightweight and easy to carry can generally be provided. Also, by using plastic, the solar timepiece dial can be formed into a desired shape comparatively easily. Additionally, by using a nonmetal material, a dial that is also well suited for a radio-controlled timepiece can be obtained.

Plastic materials from which the substrate 11 can be made include any of various thermoplastic resins and thermosetting resins. For example, the substrate can be made of any one of the following materials, a copolymer, blend, or polymer alloy made mainly of one of the following materials, or a combination of two or more of the following materials (e.g., a blend resin, polymer alloy, or laminate made with two or more of the following materials): polyolefins such as polyethylenes, polypropylenes, ethylene-propylene copolymers, and ethylene-vinyl acetate copolymers (EVA); cyclic polyolefins; modified polyolefins; polyvinyl chlorides; polyvinylidene chlorides; polystyrenes; polyamides (e.g., nylon 6, nylon 46, nylon 66, nylon 610, nylon 612, nylon 11, nylon 12, nylon 6-12, nylon 6-66); polyimides; polyamide-imides; polycarbonates (PC); poly-(4-methylpentene-1), ionomers; acrylic resins; polymethyl methacrylates; acrylonitrile-butadiene-styrene copolymers (ABS resins); acrylonitrile-styrene copolymers (AS resins); butadiene-styrene copolymers; polyoxymethylenes; polyvinyl alcohols (PVA); ethylene-vinyl alcohol copolymer (EVOH); polyesters such as polyethylene terephthalates (PET), polybutylene terephthalates (PBT), and polycyclohexane terephthalates (PCT); polyethers; polyether ketones (PEK); polyether ether ketones (PEEK); polyether imides; polyacetals (POM); polyphenylene oxides; modified polyphenylene oxides; polysulfones; polyethersulfones, polyphenylene sulfides; polyarylates; aromatic polyesters (liquid crystal polymers); polytetrafluoroethylenes, polyvinylidene fluorides, and other fluororesins; various thermoplastic elastomers based on a styrene, polyolefin, polyvinyl chloride, polyurethane, polyester, polyamide, polybutadiene, trans polyisoprene, fluororubber, or polyethylene chloride; epoxy resins, phenolic resins; urea resins; melamine resins; unsaturated polyesters; silicone resins; urethane resins; and poly-paraxylylene resins such as polyparaxylylene, poly-monochloro-paraxylylene, poly-dichloro-paraxylylene, poly-monofluoro-paraxylylene, and poly-monoethyl-paraxylylene. More particularly, the substrate 11 is preferably made mainly of polycarbonate and/or an acrylonitrile-butadiene-styrene copolymer. By using such a material, for example, particularly excellent adhesiveness can be obtained between the substrate 11 and the diffusion layer 12 (described later). Additionally, the whole solar timepiece dial 1 can be made to have particularly excellent strength, and the degree of freedom with respect to molding the solar timepiece dial 1 (substrate 11) during manufacturing thereof can be increased (i.e., the dial 1 is easier to form). Furthermore, a printed layer can be appropriately formed on the surface of the substrate 11.

The substrate 11 may be configured such that the composition thereof is substantially uniform at all positions (portions) thereof or such that the composition thereof differs depending on the position. For example, the substrate 11 may have a base part and other coating layers, such as a coloring layer provided on the base part. In such a case, the coating layer may be formed using any of various paint application methods, printing methods, wet plating methods, and dry plating methods.

There are no particular limitations on the shape and size of the substrate 11, and these are normally determined on the basis of the shape and size of the solar timepiece dial 1. Although the substrate 11 (solar timepiece dial 1) shown in the figures is shaped like a flat plate, it is also acceptable for the substrate 11 to have the shape of a curved plate.

There are no particular limitations to the color of the substrate 11 so long as the substrate 11 has optical transparency (i.e., optical transparency with respect to the wavelengths of light that can be used to drive the solar battery 9 and store electricity). When the substrate 11 is white, the solar timepiece dial 1 can exude a particularly excellent aesthetic appearance (especially when being applied to a watch 100), and the solar timepiece dial 1 and timepiece 100 can be made to appear to be of even higher quality. When the substrate 11 is substantially transparent (more specifically, when the optical transmittance with respect to visible light is 90% or higher), the solar timepiece dial 1 can be imparted with a high optical transmittance, and the size of the solar battery 9 can also be reduced.

Although there are no particular limitations to the thickness of the substrate 11, a thickness of 200 to 700 $\mu$m

is preferable, and a thickness of 300 to 600 $\mu$m is even more preferable. By setting the average thickness of the substrate 11 to a value in the aforementioned range, the solar timepiece dial 1 can more effectively prevent the base color of the solar battery 9 from being visible therethrough while also possessing sufficiently high optical transparency and, thus, can be imparted with particularly excellent decorativeness (aesthetic appearance).

Although not shown in Fig. 1, time indicating graduations (tick marks), decorative lettering, and other markings are provided on the external surface of the substrate 11 (the side of the substrate 11 that is opposite to the side facing the solar battery 9).

[Diffusion Layer]

The diffusion layer 12 is made of a material containing a diffusing agent that functions to diffuse incident light. Thus, while light (external light) incident on the diffusion layer 12 from the substrate 11 side is emitted toward the polarizer 13 (described later), a portion of the incident light can also be diffused back toward the substrate 11. Similarly, the light that is incident on the diffusion layer 12 from the polarizer 13 (described later) side can be emitted while being diffused toward the substrate 11. As a result, the light (external light) that is incident on the diffusion layer 12 from the substrate 11 side can be emitted the polarizer 13 (solar battery 9) while also effectively preventing the solar battery 9 from being visible through the solar timepiece dial 1. In other words, the solar timepiece dial 1 can be imparted with an excellent aesthetic appearance (particularly when being applied to a timepiece 100) and still allow the light required to drive the solar battery 9 and store electricity to be emitted toward the solar battery 9. In particular, since the diffusion layer 12 causes light to be emitted (diffused) toward the substrate 11, the appearance of the solar timepiece dial 1 has a higher degree of whiteness and the solar timepiece dial 1 appears to be of higher quality.

The diffusing agent used in the diffusion layer 12 may be anything so long as it functions to diffuse light.

The diffusing agent may have any shape or form, such as a particulate (powdery) shape, a scale shape, or a needle shape, or it can have an irregular form. It is also acceptable for the diffusion layer 12 to be made substantially of the diffusing agent alone.

Examples of the material from which the diffusing agent can be made include silica, glass, and resin.

The diffusion layer 12 is preferably made of a material having an adhesive or bonding property. By using such a material, the adhesiveness between the substrate 11 and the polarizer 13 can be improved, and consequently, the shock resistance of the solar timepiece dial 1 can be improved, enabling the solar timepiece dial 1 to function exceptionally reliably as both a practical component and a decorative component.

Examples of materials having an adhesive or bonding property (adhesive/bonding material) include any material that is used as an adhesive or bonding agent, but it is preferable to use an acrylic resin as the adhesive/bonding agent. By using an acrylic resin material, particularly excellent adhesiveness can be achieved between the substrate 11 and the polarizer 13 while sufficiently maintaining the overall optical transparency and aesthetic appearance of the solar timepiece dial 1.

When the diffusion layer 12 includes an adhesive/bonding material as described above, it is preferable for the diffusion layer 12 to be made mainly of the adhesive/bonding material. By making the diffusion layer 12 mainly of the adhesive/bonding material, the aforementioned effects can be exhibited more demonstrably.

[Polarizer]

The polarizer 13 functions to polarize light that is incident thereon.

The inventor has discovered that, by arranging the polarizer 13 closer to the solar battery 9 than the substrate 11 (particularly by configuring the dial 1 such that the polarizer 13, the diffusion layer 12, the substrate 11 are arranged in this order from closest to farthest relative to the solar battery 9), the solar timepiece dial 1 can effectively prevent the base color of the solar battery 9 from being visible therethrough while also possessing sufficiently high optical transparency, and the solar timepiece dial 1 can be imparted with particularly excellent decorativeness (aesthetic appearance).

Although it is acceptable for the polarizer 13 to be anything that functions to polarize incident light, it is preferred for the polarizer 13 to be a reflective polarizer configured to transmit a first light that vibrates in a prescribed direction and reflect a second light having a vibrational direction that is perpendicular to the vibrational direction of the first light. By configuring the polarizer 13 in this manner, the solar timepiece dial 1 can prevent the base color of the solar battery 9 from being visible therethrough while also possessing sufficiently high optical transparency and can be imparted with particularly excellent decorativeness (aesthetic appearance).

The polarizer (reflective polarizer) 13 can be made of any material. For example, it can be made mainly of a polyester resin. By using a polyester resin, the overall optical transmittance of the solar timepiece dial 1 decreases and the base color of the solar battery can be prevented even more effectively from being visible through the dial 1. Also, when a white substrate 11 is used, the whiteness of the solar timepiece dial 1 as a whole can be improved.

Also, the polarizer (reflective polarizer) 13 is preferably a film (laminate) formed by laminating a plurality of layers. By configuring the polarizer 13 as a film, the solar timepiece dial 1 can prevent the base color of the solar battery 9 from being visible therethrough while also possessing sufficiently high optical transparency and can be imparted with particularly excellent decorativeness (aesthetic appearance) .

FIG. 2 shows a preferred embodiment of a polarizer 13 formed by laminating a plurality of layers.

As shown in FIG. 2, the polarizer 13 as a laminate is made of two types of layers, i.e., a polarizing film layer (A layer) 131 and a polarizing film layer (B layer) 132, that are laminated on top of one another in an alternating fashion. In this polarizer 13, the refractive index ($n_{AX}$) of the A layer 131 in the X-axis direction is different from the refractive index ($n_{BX}$) of the B layer 132 in the X-axis direction, but the refractive index ($n_{AY}$) of the A layer 131 in the X-axis direction and the refractive index ($n_{BY}$) of the B layer 132 in the X-axis direction are substantially equal. Since the refractive indexes both the A layer 131 and the B layer 132 in the Y-axis direction are substantially the same, the portion of light incident on the polarizer 13 that is linearly polarized in the Y-axis direction passes through the polarizer 13. Meanwhile, assuming the average thickness of the A layer 131 in the Z-axis direction is $t_A$ and the average thickness of the B layer 132 is $t_B$, when light having a wavelength $\lambda$ is incident on the polarizer 13, the portion of the incident light that is linearly polarized in the X-axis direction will be appropriately reflected by the polarizer 13 as represented by the equation (I) below.

$$t_A \cdot n_{AX} + t_B \cdot n_{BX} = \lambda/2 \qquad (1)$$

Since the average thicknesses of the A layers 131 in the Z-axis direction and the average thicknesses of the A layers 132 in the Z-axis direction are varied, the polarizer 13 reflects a wide range of visible wavelengths of incident light that is linear polarized in the X-axis direction.

With such a polarizer 13, a portion of the light incident on the dial 1 can pass through the dial 1 and be used to store energy in the solar battery 9, and a portion of the incident light can be reflected so as to efficiently prevent the base color of the solar battery 9 arranged under the substrate 11 from being visible through the dial 1.

When the polarizer 13 is made of laminate as described above, each layer (A layer 131 and B layer 132) may be made of any material. However, it is preferable that the A layer 131 of the polarizer 13 be made of polyethylene naphthalate (particularly, a drawn film made of polyethylene naphthalate) and the B layer 132 be made of co-polyester comprising naphthalene dicarbonate and terephthalate. By making the layers of the polarizer 13 out of such materials, the solar timepiece dial 1 can prevent the base color of the solar battery 9 from being visible therethrough while also possessing sufficiently high optical transparency and can be imparted with particularly excellent decorativeness (aesthetic appearance). Additionally, the materials used to make the polarizer 13 are not limited to those mentioned above. Any material that is known to be well suited for forming a polarizing film (polarizing plate) in this technical field can be selected and used as appropriate depending on the particular design considerations.

There are no particular limitations to the number of layers provided when the polarizer 13 is a laminate as described above, but is preferable for 2 to 20 layers to be provided, more preferable for 6 to 12 layers to be provided, and still more preferable for 8 to 10 layers to be provided. By providing the preferred number of layers, the aforementioned effects can be exhibited more demonstrably.

Although there are no particular limitations to the thickness of the polarizer 13, a thickness of 20 to 300 $\mu$m is preferable and a thickness of 100 to 200 $\mu$m is even more preferable. By setting the average thickness of the polarizer 13 to a value in the aforementioned range, the solar timepiece dial 1 can more effectively prevent the base color of the solar battery 9 from being visible therethrough while also possessing sufficiently high optical transparency and, thus, can be imparted with particularly excellent decorativeness (aesthetic appearance) .

[Solar Timepiece Dial]

A solar timepiece dial 1 is arranged on a timepiece (solar timepiece) in a position above the solar battery 9 (on the side of the solar battery 9 configured to receive light).

It is preferable that the optical transmittance of the solar timepiece dial 1 be 20% or higher with respect to visible light traveling from the substrate 11 side toward the polarizer 13 side. It is more preferable that the same optical transmittance be in the range of 21% to 80% and still more preferable that the same optical transmittance be in the range of 22% to 70%. When the optical transmittance is in such a range, the light incident on the solar timepiece dial 1 can be made to be more efficiently incident on the solar battery 9 while sufficiently maintaining the excellent decorativeness (aesthetic appearance) of the solar timepiece dial 1 (and of the entire timepiece in which the solar timepiece dial 1 is provided). On the contrary, if the optical transmittance is too low, it will sometimes be difficult for an amount of light sufficient to drive the solar battery 9 and store electricity to be incident on the solar battery 9. Meanwhile, if the optical transmittance is too high, it might be difficult to achieve sufficiently excellent decorativeness (sufficient aesthetic appearance) for the solar timepiece dial 1 (and for the entire timepiece in which the solar timepiece dial 1 is provided).

The solar timepiece dial 1 can be any color but it is preferable for it to have a white appearance. When it is white, the solar timepiece dial 1 can exude particularly excellent decorativeness (especially a feeling of high quality).

An example of a method of manufacturing the solar timepiece dial 1 described above will now be described.

First, the diffusion layer 12 is formed on the back surface (non-printed surface) of the substrate 11 using a paint application method or other methods. The substrate 11 and the diffusion layer 12 can be made of any of the respective materials described previously. Next, the polarizer 13 is attached to the surface of the diffusion layer 12 formed on the substrate 11. If the diffusion layer 12 is made of an adhesive/bonding material as described above, the attachment of the polarizer 13 to the substrate 11 can be accomplished more efficiently. The polarizer 13 can be a polarizer like that described previously. By heating a structure comprising a substrate 11, diffusion layer 12, and polarizer 13 as just described (more specifically, by curing the material constituting the diffusion layer 12), a stronger adhesiveness can be obtained between the polarizer 13 and the substrate 11.

The solar timepiece dial described heretofore may be applied to any solar timepiece but it is preferably applied to a wristwatch (as a wristwatch dial). The environment in which a wristwatch is used is typically not fixed, and the wristwatch needs to possess excellent decorative and practical properties suitable for a variety of environments. Furthermore, the wristwatch dial used in a solar wristwatch (solar wristwatch dial) needs to have particularly excellent decorativeness and optical transparency as compared with other solar timepiece dials. Therefore, although the invention is applicable to various timepiece dials (solar timepiece dials), it is particularly well suited for wristwatch dials.

A timepiece according to the invention that is provided with a solar timepiece dial according to the invention will now be described.

A timepiece according to the invention has a solar timepiece dial according to the invention, i.e., a solar timepiece dial as described above. As described above, a solar timepiece dial according to the invention has excellent optical transparency and excellent decorativeness (an excellent aesthetic appearance). Consequently, since it is provided with such a solar timepiece dial, a timepiece according to the invention can easily satisfy the requirements of a solar timepiece. Except for the timepiece components described previously, any commonly known parts can be used as the component parts of a timepiece according to the invention. However, an example of the component parts of a timepiece according to the invention will now be described.

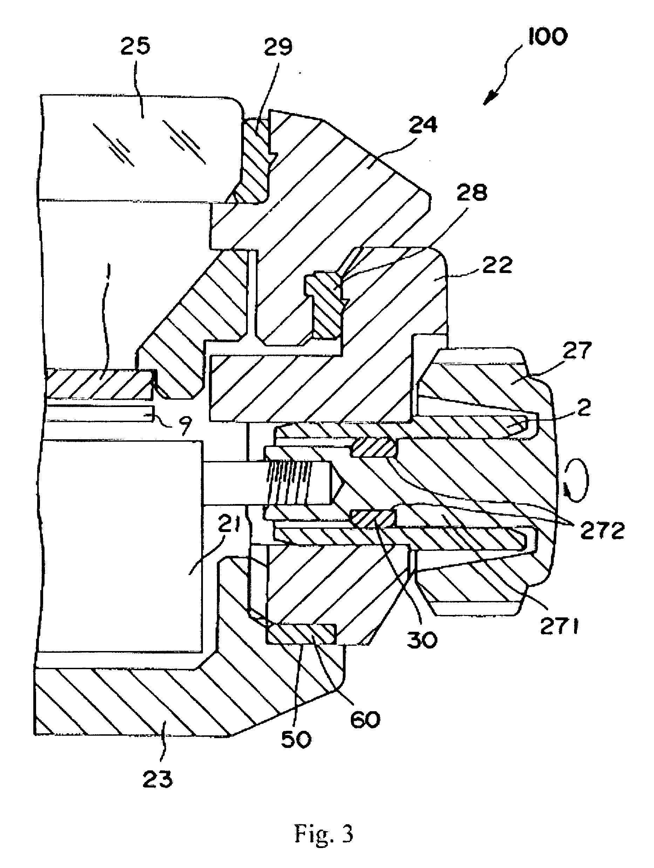

Fig. 3 is a sectional view showing a preferred embodiment of a timepiece (wristwatch) according to the invention.

As shown in Fig. 3, the wristwatch (portable timepiece) 100 of this embodiment has a body (case) 22, a back cover 23, a bezel (edge) 24, and a glass plate (glass cover) 25. A solar timepiece dial 1 as described previously, a solar battery 9, and a movement 21 are housed inside the case 22. Additionally, hands (time indicating needles) which are not shown in the figures are also housed inside the case 22.

The glass plate 25 is normally made of transparent glass, sapphire, or material having a high degree of transparency. As a result, the aesthetic beauty of the solar timepiece dial 1 can be exhibited thoroughly and a sufficient amount of light can be caused to be incident on the solar battery 9.

The movement 21 uses electromotive force from the solar battery 9 to drive the hands.

Although omitted from Fig. 3, the movement 21 includes, for example, an electric double layer capacitor configured and arranged to store the electromotive force of the solar battery 9, a lithium ion secondary battery, a crystal oscillator serving as a time reference, a semiconductor integrated circuit configured to generate drive pulses for driving the timepiece on the basis of the oscillating frequency of the crystal oscillator, a stepping motor configured to receive the drive pulses and drive the hands once per second, and a wheel train mechanism for transmitting the movement of the stepping motor to the hands.

The solar battery 9 functions to convert light energy into electrical energy. The electric energy converted by the solar battery 9 is then used to drive a movement.

The solar battery 9 has, for example, a PIN structure comprising a non-single-crystal silicon thin film selectively doped with a p-type impurity, a non-single-crystal silicon thin film selectively doped with an n-type impurity, and an i-type non-single-crystal silicon thin film having a low impurity concentration arranged between the p-type non-single-crystal silicon thin film and the n-type non-single-crystal silicon thin film.

A winding stem pipe 26 is fitted and thereby fixed into the body 22, and a shaft part 271 of a winding crown 27 is rotatably inserted into the winding stem pipe 26.

The bezel 24 and body 22 are fastened together by means of plastic packing 28, and the bezel 24 and glass plate 25 are fastened together by means of plastic packing 29.

The back cover 23 is fitted (or screwed) to the body 22 and a ring-shaped rubber packing (back cover packing) 60 is inserted into a joint (seal part) 50 between the back cover and body in a compressed state. This arrangement seals the seal part 50 in a watertight manner, thereby providing a waterproofing effect.

A groove 272 is formed in the outer periphery of the shaft part 271 of the winding crown 27 and a ring-shaped rubber packing (crown packing) 30 is fitted into this groove 272. The rubber packing 30 fits snugly against the inner peripheral surface of the winding stem pipe 26 and is compressed between the inner peripheral surface of the winding stem pipe 26 and the inner surface of the groove 272. This arrangement seals the gap between the crown 27 and the winding stem pipe 26 in a watertight manner, thereby providing a waterproofing effect. When the crown 27 is wound, the rubber packing 30 turns together with the winding stem 271 and slides in a peripheral direction along the inner peripheral surface of the winding stem pipe 26 while maintaining a snug fit against the inner peripheral surface.

Although the preceding explanation presents an example of a wristwatch (portable timepiece), the invention can also be applied in a similar fashion to portable timepieces other than wristwatches, desk clocks, wall clocks etc.

Although the preceding explanation presents a preferred embodiment of a solar timepiece dial according to the invention and a timepiece equipped with the same, the invention is not limited to the solar timepiece dial and timepiece described in the embodiment.

For example, in the preceding embodiment, the substrate 11 and the diffusion layer 12 contact each other, and the diffusion layer 12 and the polarizer 13 contact each other, but the invention is not limited to such a contacting arrangement. It is also acceptable, for example, for at least one intermediate layer to be provided between the substrate 11 and the diffusion layer 12 and/or between the diffusion layer 12 and the polarizer 13.

Also, a timepiece according to the invention is within the scope of the invention so long as it has a substrate, a diffusion layer, and a polarizer; it is not necessary for the substrate, diffusion layer, and polarizer to be joined together. In other words, in a timepiece according to the invention, it is acceptable if the substrate, diffusion layer, and polarizer do not exist as a single unified dial. For example, the substrate (dial), the diffusion layer (diffuser), and the polarizer can exist as separate members.

EXAMPLES

Specific examples of the invention will now be described.

[Manufacture of Solar Timepiece Dial (Wristwatch Dial)]

Example 1

A wristwatch dial was made using a method that will now be described.

First, a substrate having the shape of a wristwatch dial was fabricated by compression-molding a polycarbonate material, and the required portions were then cut and polished. The substrate obtained had a substantially circular disk-like shape with a diameter of 27 mm and a thickness of 0.5 mm.

After fabrication, the substrate was washed. The washing of the substrate was conducted as follows. First alkaline electrolytic degreasing was performed for 30 seconds, followed by 30 seconds of alkaline dip degreasing. Then, the neutralization was performed for 10 seconds followed by water rinsing for 10 seconds and pure water cleaning for 10 seconds.

Next, a surface of the substrate was painted white and air-dried and the side of the substrate opposite to the side that was painted white was printed with time markings (time indicating graduations, etc.) and air-dried.

Meanwhile, a polarizer (reflective polarizer) made of a polyester resin was prepared. The polarizer was fabricated by drawing a sheet material made of a polyester resin in one axial direction and punching the sheet material so as to obtain a substantially disc-shaped member (polarizer) having a diameter of 27 mm. The average thickness of the polarizer was 20 $\mu$m.

Next, a diffusion layer composite material containing a diffusing agent and an acrylic adhesive (acrylic resin) was used to attach the substrate described previously (substrate that was painted white) and the polarizer together, thereby obtaining a solar timepiece dial comprising a substrate, a diffusion layer, and a polarizer arranged in a laminated fashion. The substrate and the polarizer were attached together in such a manner that the diffusion layer contacted the surface of the substrate that was painted white. Silica powder was used as the diffusing agent.

Example 2

The wristwatch dial manufactured in this working example was the same as the dial described in Working Example 1 except that the polarizer (reflective polarizer) was made of a film (laminate) comprising a plurality of layers laminated on top of one another (as described below).

The polarizer used in this working example is made up of two types of layers: a layer comprising a sheet material obtained by drawing a sheet material made of polyethylene naphthalate in one axial direction and a layer comprising a sheet material obtained by drawing a sheet material made of co-polyester of naphthalene dicarbonate and terephthalate. The two types of layers were laminated on top of one another alternately to obtain a total of eight layers. The average thickness of the polarizer was 160 $\mu$m.

Comparative Example 1

A wristwatch dial was manufactured that was the same as the dial described in Working Example 1 except that an antireflective layer comprising an antireflective film was formed instead of a polarizer.

Comparative Example 2

A wristwatch dial was manufactured that was the same as the dial described in Working Example 1 except that a reflective layer comprising a reflective film was formed instead of a polarizer.

Comparative Example 3

A wristwatch dial was manufactured that was the same as the dial described in Working Example 1 except that an adhesive layer made substantially of an acrylic adhesive alone and not containing a diffusing agent was formed instead of a diffusion layer.

Comparative Example 4

A wristwatch dial was manufactured that was the same as the dial described in Working Example 2 except that an adhesive layer made substantially of an acrylic adhesive alone and not containing a diffusing agent was formed instead of a diffusion layer.

[Evaluation]

1. Evaluation of Optical Transmittance of Wristwatch Dial

The optical transmittance of each of the solar timepiece dials obtained in the working examples and comparative examples was evaluated by a method of evaluation that will now be described.

First, the dials were placed in a dark chamber with a solar battery. Then, the light from a fluorescent lamp (light source) was caused to be incident onto a light-receiving surface of the solar battery alone from a prescribed distance. The electric current (mA) generated by the solar battery under these conditions was called "A." The light-receiving surface of the solar battery was then covered with one of the dials, and the light from a fluorescent lamp (light source) was caused to be incident from a prescribed distance in the same manner as the standalone test just described. The electric current (mA) generated by the solar battery under these conditions was called "B." Next, the optical transmittance of each dial was calculated as a percentage using the expression (B/A) x 100 and ranked into one of the four reference categories shown below. The larger the optical transmittance of each dial, the more excellent the optical transparency of the solar timepiece dial can be said to be.

◎:    22% or higher
O:    equal to or larger than 20% but less than 22%
Δ:    equal to or larger than 11% but less than 20%
X:    less than 11%

Thereafter, wristwatches as shown in Fig. 3 were manufactured using the wristwatch dials manufactured in the working examples and comparative examples described previously. The manufactured wristwatches were then placed in a dark chamber. The light from a fluorescent lamp (light source) was caused to be incident onto the surface of the dial of the wristwatch (surface of the glass plate) from a prescribed distance. At this time, the intensity of the light was gradually increased at a constant speed. As a result, it was demonstrated that the movement of a timepiece according to the invention can be driven even if the intensity of the light incident on the surface of the dial is relatively small. In contrast, the movement of the timepiece equipped with the dial of Comparative Example 2 did not operate even when the intensity of the incident light was comparatively large.

2. Evaluation of Aesthetic Appearance of Wristwatch Dial

Wristwatches equipped with the solar timepiece dials obtained in the working examples and comparative examples were observed visually, and the appearance of each watch was ranked into one of the four reference categories shown below.

◎:    Superior appearance
O:    Good appearance

Δ:     Somewhat flawed appearance

X:     Flawed appearance

The results of the optical transmittance and appearance evaluations are shown in Table 1.

TABLE 1

|  | Optical Transmittance of Dial External Appearance | Appearance Evaluation |
|---|---|---|
| Working Example 1 | ◎ | O |
| Working Example 2 | ◎ | ◎ |
| Comparative Example 1 | ◎ | X |
| Comparative Example 2 | X | X |
| Comparative Example 3 | ◎ | X |
| Comparative Example 4 | ◎ | X |

As clear from the results shown in Table 1, when a timepiece is provided with a solar timepiece dial according to the invention, the excellent optical transparency of the solar timepiece dial enables an amount of light sufficient to drive the solar battery and store electricity to be supplied to the solar battery and the decorativeness of the solar timepiece dial enable the timepiece to exude an excellent aesthetic appearance.

In contrast, the wristwatches equipped with solar timepiece dials (solar timepiece dials) of the comparative examples did not demonstrate satisfactory results. In particular, the dials of Comparative Examples 3 and 4 with no diffusion layers have demonstrably poor aesthetic appearances.

Industrial Applicability

The solar timepiece dial according to the invention is a solar timepiece dial that is used in a solar timepiece equipped with a solar battery, and includes a substrate made of a material having optical transparency, a polarizer provided on the surface of the substrate that faces the solar battery and functioning to polarize incident light, and a diffusion layer made of a material containing a diffusing agent functioning to diffuse incident light and arranged between the substrate and the polarizer. Therefore, a solar timepiece dial having excellent optical transparency and excellent decorativeness (aesthetic appearance) can be provided. Also, the timepiece according to the invention includes the solar timepiece dial according to the invention. Therefore, a timepiece (solar timepiece) that can supply a sufficient amount of external light to a solar battery and has excellent decorativeness can be provided. Accordingly, the solar timepiece dial and timepiece according to the invention have industrial applicability.

**Claims**

1.   A solar timepiece dial used in a solar timepiece equipped with a solar battery, the solar timepiece dial comprising:

   a substrate made of a material having optical transparency;
   a polarizer provided on the surface of the substrate that faces the solar battery and functioning to polarize incident light; and
   a diffusion layer made of a material containing a diffusing agent functioning to diffuse incident light and arranged between the substrate and the polarizer.

2.   The solar timepiece dial according to Claim 1, wherein the polarizer is a reflective polarizer configured to transmit a first light that vibrates in a prescribed direction and reflect a second light having a vibrational direction that is perpendicular to the vibrational direction of the first light.

3.   The solar timepiece dial according to Claim 1 or 2,
   wherein the polarizer is a film formed by laminating a plurality of layers.

4.   The solar timepiece dial according to any one of Claims 1 to 3,
   wherein the polarizer is a film formed by alternately laminating a layer made mainly of polyethylene naphthalate

**EP 1 775 647 A1**

and a layer made mainly of co-polyester of naphthalene dicarbonate [Another word :

dicarboxylic acid]and terephthalate.

5. The solar timepiece dial according to any one of Claims 1 to 4,
   wherein the polarizer is made mainly of a polyester resin.

6. The solar timepiece dial according to any one of Claims 1 to 5,
   wherein the diffusion layer is made of a material having an adhesive or bonding property.

7. The solar timepiece dial according to any one of Claims 1 to 6,
   wherein the diffusion layer is made mainly of an acrylic adhesive.

8. The solar timepiece dial according to any one of Claims 1 to 7,
   wherein the substrate is made mainly of polycarbonate and/or an acrylonitrile-butadiene-styrene copolymer.

9. The solar timepiece dial according to any one of Claims 1 to 8,
   wherein the optical transmittance of visible light traveling from the side where the substrate is provided to the side where the polarizer is provided is 20% or higher.

10. The solar timepiece dial according to any one of Claims 1 to 9,
    wherein the dial timepiece dial possesses a white external appearance.

11. The solar timepiece dial according to any one of Claims 1 to 10,
    wherein the solar timepiece dial is a dial for a wristwatch.

12. A timepiece comprising:

    a solar battery;
    a substrate made of a material having optical transparency;
    a polarizer provided on the surface of the substrate that faces the solar battery and functioning to polarize incident light;
    a diffusion layer made of a material containing a diffusing agent functioning to diffuse incident light and arranged between the substrate and the polarizer.

13. A timepiece comprising a solar timepiece dial according to any one of Claims 1 to 11.

1

11

12

13

9

Fig. 1

Fig. 2

Fig. 3

**INTERNATIONAL SEARCH REPORT**

| International application No. |
| --- |
| PCT/JP2005/011811 |

A. CLASSIFICATION OF SUBJECT MATTER
Int.Cl$^7$  G04B19/06, G02B5/30, H01L31/04

According to International Patent Classification (IPC) or to both national classification and IPC

B. FIELDS SEARCHED

Minimum documentation searched (classification system followed by classification symbols)
Int.Cl$^7$  G04B19/06, G02B5/30, H01L31/04

Documentation searched other than minimum documentation to the extent that such documents are included in the fields searched

| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y | JP 11-298026 A  (Seiko Instruments Inc. et al.), 29 October, 1999 (29.10.99), Par. Nos. [0026] to [0028], [0040]; Fig. 6 (Family: none) | 1-13 |
| Y | EP 1184911 A1  (Citizen Watch Co., Ltd.), 06 March, 2002 (06.03.02), Par. Nos. [0088] to [0143]; Fig. 11 & US 6518493 B1     & WO 01/037350 A1 & AU 1304001 A     & BR 7484 A & CN 1343375 T | 1-13 |
| Y | JP 11-101976 A  (Seiko Epson Corp.), 13 April, 1999 (13.04.99), Par. No. [0053] (Family: none) | 3-5 |

| ☒ | Further documents are listed in the continuation of Box C. | | ☐ | See patent family annex. |

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| 22 July, 2005 (22.07.05) | 09 August, 2005 (09.08.05) |

| Name and mailing address of the ISA/ | Authorized officer |
| --- | --- |
| Japanese Patent Office | |
| Facsimile No. | Telephone No. |

Form PCT/ISA/210 (second sheet) (January 2004)

**EP 1 775 647 A1**

**INTERNATIONAL SEARCH REPORT**

International application No.

PCT/JP2005/011811

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2003-315545 A  (Nitto Denko Corp.), 06 November, 2003 (06.11.03), Par. No. [0034] (Family: none) | 7 |

Form PCT/ISA/210 (continuation of second sheet) (January 2004)

**REFERENCES CITED IN THE DESCRIPTION**

**Patent documents cited in the description**

- JP 10039048 A